**Europäisches Patentamt**

**European Patent Office**

**Office européen des brevets**

(19)

(11) Veröffentlichungsnummer: **0 048 297
B1**

(12) # EUROPÄISCHE PATENTSCHRIFT

(45) Veröffentlichungstag der Patentschrift:
**09.05.84**

(21) Anmeldenummer: **80105701.9**

(22) Anmeldetag: **23.09.80**

(51) Int. Cl.³: **G 03 B 17/24,** G 03 B 27/02,
B 41 F 13/02, G 03 F 1/02

(54) **Vorrichtung und Verfahren zur Herstellung von Schriftzeichen, insbesondere von Titelsatz, auf einem Fotomaterial.**

(43) Veröffentlichungstag der Anmeldung:
**31.03.82 Patentblatt 82/13**

(45) Bekanntmachung des Hinweises auf die Patenterteilung:
**09.05.84 Patentblatt 84/19**

(84) Benannte Vertragsstaaten:
**AT BE CH DE FR GB IT LI LU NL SE**

(56) Entgegenhaltungen:
**DE - A - 2 146 138
DE - B - 1 145 490
US - A - 2 883 918**

(73) Patentinhaber: **PROJECTALINE AG, Postfach,
CH-Vitznau/Luzern (CH)**

(72) Erfinder: **Goetschi, Fred, Haus zum Anker,
CH-6354 Vitznau (CH)**

(74) Vertreter: **Blumbach Weser Bergen Kramer Zwirner
Hoffmann Patentanwälte, Sonnenbergerstrasse 43,
D-6200 Wiesbaden 1 (DE)**

## Beschreibung

Die Erfindung bezieht sich auf eine Vorrichtung zur fotografischen Herstellung von Schriftzeichen usw., insbesondere für den Titelsatz, auf mit Entwicklerlösung getränktem fotografischem Material, das eine Verarbeitung bei gedämpftem Tageslicht erlaubt, sowie auf ein Verfahren zur Herstellung der Schriftzeichen.

Bei der Herstellung von Text- und Kopiervorlagen auf fotografischem Wege verwendet man eine Projektionsvorrichtung, um unter optischer Kontrolle Typenbilder oder andere Kompositionselemente auf ein mit Entwicklerlösung getränktes fotografisches Material mit steiler Gradation und geringer Allgemeinempfindlichkeit zu projizieren (DE-B-1 145 490). Das verwendete Material ist für die Kontaktkopie von Strichvorlagen in der fotomechanischen Reproduktion hergestellt und ermöglicht ein Arbeiten bei gedämpftem Tages- oder Glühlampenlicht.

Bei fotografischem Druck ist es ferner bekannt (US-A-2 883 918), eine lichtundurchlässige Unterlage mit auf der Unterseite aufgebrachtem fotografischem Material zusammen mit einem oberen Layoutblatt an einer Schiene zu befestigen und – dazwischengefügt – ein Negativzeichenblatt zusammen mit einem übereinstimmenden Indexzeichenblatt an einer weiteren Schiene zu befestigen, so dass das Negativzeichenblatt und das fotografische Material an passender Stelle übereinander und über ein Lichtfenster gerückt werden können. Zur Kontrolle dient das Indexzeichenblatt, auf welches ein Indexlichtfenster – deckend zum Lichtfenster – projiziert wird. Bei richtiger Ausrichtung wird die Drucklichtquelle angeschaltet und das fotografische Material durch das Negativzeichenblatt hindurch belichtet. Nachteilig ist der apparative Aufwand und die nicht einfache Bedienung.

Die Erfindung bietet eine einfache Möglichkeit der Herstellung von Schriftzeichen usw., insbesondere für den Titelsatz. Die Vereinfachung erstreckt sich sowohl auf den apparativen Aufwand als auch auf die Bedienung.

Die Lösung der gestellten Aufgabe ergibt sich aus der Lehre des Anspruchs 1 bzw. 14.

Im einzelnen befeuchtet man das fotografische Material mit Entwicklungsflüssigkeit und bedeckt es mit einem transparenten Deckfilm, legt die Aufzeichnungsträgerfolie auf die Stelle des fotografischen Materials, an der das Schriftzeichen usw. hergestellt werden soll, bestrahlt diese Stelle mit kurzwelligem Licht, indem man das darüber gehaltene Blitzlichtgerät auslöst, und erhält sogleich das Schriftzeichen usw. Der Lichtkasten durchscheint das Fotomaterial und die darüber aufgelegte Aufzeichnungsträgerfolie, so dass die weitere Ausrichtung bei der Wahl des nächsten Schriftzeichens erleichtert ist. Das durchscheinende Licht des Lichtkastens liegt im sichtbaren Bereich, für welchen das fotografische Material nur schwach empfindlich ist, so dass für den Aufzeichnungsvorgang das kurzwellige Licht des Blitzlichtgeräts entscheidend ist.

Ein Ausführungsbeispiel der Erfindung wird anhand der Zeichnung beschrieben. Dabei zeigt:

Fig. 1 einen Schnitt durch die Vorrichtung, abgebrochen, und

Fig. 2 eine perspektivische, auseinandergezogene Darstellung der Einzelteile der Vorrichtung nach Fig. 1.

Diese Einzelteile sind:

ein gelbes Licht abgebender und als Unterlage dienender Lichtkasten 1, ein schwach lichtempfindliches und mit Entwicklerflüssigkeit vorbefeuchtetes Fotomaterial 10 in Form von Papier oder Film, eine mit einem Liniennetz 13 (auf vorzugsweise Millimeternetz) versehene, transparente Deckfolie 12, eine Aufzeichnungsträgerfolie 15 für herzustellende Schriftzeichen, Symbole, Bilder, Fotos oder dergleichen, die als durchlässige Bereiche auf einem Grund erscheinen der undurchlässig für kurzwelliges Licht ist, und ein tragbares Blitzlichtgerät 20, auch für kurzwelliges Licht.

Der Lichtkasten 1 enthält innerhalb eines lichtundurchlässigen Gehäuses 2 in einer Fassung 4 eine gelbes Licht abgebende Leuchtröhre 3 und ist oberseitig durch eine lichtdurchlässige Auflageplatte 5 aus Glas oder dergleichen abgedeckt, die vorzugsweise durch Ätzen oder dergleichen so präpariert ist, dass das von der Leuchtröhre 3 abgegebene gelbe Licht diffus nach oben aus dem Lichtkasten 1 abgegeben wird. Die Leuchtröhre 3 wird beispielsweise durch ein nicht dargestelltes Kabel aus dem Netz mit Strom versorgt.

Das Fotomaterial 10 ist im sichtbaren Lichtbereich nur schwach empfindlich, d.h. auch für blau unempfindlich, so dass nach seiner Belichtung mit kurzwelligem Licht zwar die Schriftzeichen 11, nicht aber das blaugetönte Liniennetz 13 erscheinen. Der fertige Titelsatz kann durch Fixieren und Wässern haltbar gemacht werden.

Die transparente Folie 12 besteht aus Material, welches für Entwicklerflüssigkeit undurchlässig ist. Das aufgedruckte Liniennetz (Millimeternetz) 13 ist blaugetönt, damit es auf dem auf die Farbe Blau nicht ansprechenden Fotomaterial 10 nicht abgebildet werden kann. Das Liniennetz erleichtert die Positionierung von herzustellenden Schriftzeichen 16 oder dergleichen, welche die nachstehend ausführlich beschriebene Negativfolie 15 trägt.

Die Negativfolie 15 ist im Bereich der herzustellenden Schriftzeichen 16 oder dergleichen transparent, im Restbereich jedoch orange oder sepiafarbig getönt, um hier kurzwelliges Licht nicht durchzulassen. Die Negativfolie 15 kann beispielsweise als Diazofilm ausgebildet sein. Die darauf aufgebrachten Zeichen in Negativform können Buchstaben, Zahlen, Symbole, zeichnerische Darstellungen, Fotos oder dergleichen sein. Die abzubildenden Zeichen 16 werden direkt auf die transparente Folie 12 aufgelegt, und das Liniennetz erleichtert das genaue Positionieren der Zeichen. Mit Hilfe des als Auflage dienenden Lichtkastens 1 werden belichtete, geschwärzte Zeichen mühelos erkannt, und es können die jeweils nachfolgenden Zeichen eingepasst werden.

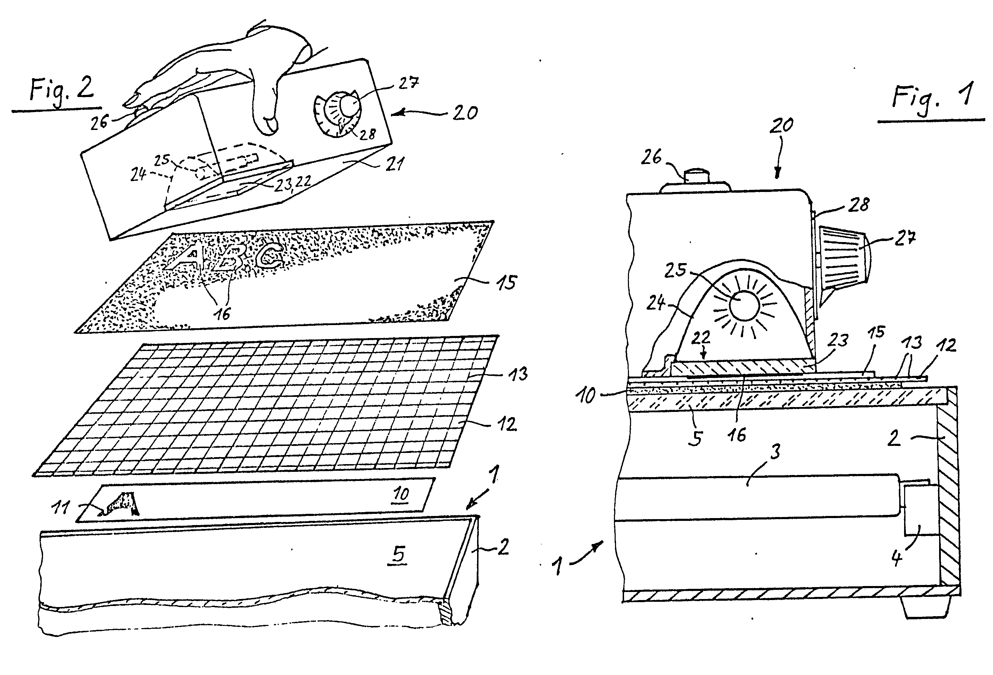

Vor jedem Belichtungsvorgang eines einzelnen Zeichens 16 werden die gemäss Fig. 1 oder 2 übereinandergelegten Materialien bzw. Folien 10, 12 und 15 im Belichtungsbereich durch eine als Andruckplatte dienende Glasplatte 23 des Blitzlichtgerätes 20 flach aufeinander gepresst, um Lichtüberstrahlungen am Rand des herzustellenden Zeichens 16 zu vermeiden. Die Glasplatte 23 überdeckt eine Lichtöffnung 22 innerhalb der als ebene Fläche ausgebildeten Unterseite 21 des Blitzlichtgerätes 20. Die Grösse der Lichtöffnung 22 ist im vorliegenden Ausführungsbeispiel etwas grösser als das herzustellende Schriftzeichen 16 gewählt.

Nach einer Weiterbildung des Erfindungsgedankens ist vorgesehen, die Grösse der Lichtöffnung 22 durch in der Zeichnung nicht dargestellte, verschiebbare Blenden bei Bedarf zu verändern und an unterschiedliche Zeichengrössen anzupassen.

Das hier verwendete Blitzlichtgerät 20 enthält eine aus einer eingebauten oder äusseren Stromquelle (nicht dargestellt), nach Betätigung eines Auslöseknopfes 26 mit Energie versorgbare Blitzlichtlampe 25 und ist in der Lage, in sehr rascher Folge sehr viele Blitze gleicher Intensität abzugeben. Die Blitzintensität kann mittels eines gegenüber einer Skala 28 verdrehbaren Einstellknopfes 27 mit Zeiger verändert werden, beispielsweise in der Weise, dass bei einer Blitzoperation mehr oder weniger Blitze gleicher Intensität nacheinander abgegeben werden.

Gemäss Fig. 2 grenzt die auch als Andruckplatte dienende Glasplatte 23 an zwei äussere Ränder der ebenen Unterseite 21 des Blitzlichtgerätes 20 an. Diese Anordnung erleichtert das Positionieren des Blitzlichtgerätes 20 über dem herzustellenden Zeichen 16 auf der Negativfolie 15 wesentlich.

Die Blitzlichtlampe 25 ist innerhalb des Blitzlichtgeräts 20 bis zur Lichtöffnung 20 mit einem im Querschnitt parabelförmigen Reflektor 24 umgeben, welcher das Blitzlicht auf die Lichtöffnung 22 bündelt.

**Patentansprüche**

1. Vorrichtung zur fotografischen Herstellung von Schriftzeichen usw., insbesondere für den Titelsatz, auf mit Entwicklerlösung getränktem fotografischem Materrial (10), das eine Verarbeitung bei gedämpftem Tageslicht erlaubt, dadurch gekennzeichnet, dass zur Beobachtung ein Lichtkasten (1) vorgesehen ist, der eine nicht aktinisches Licht abgebende Lichtquelle (3) und eine ebene Auflageplatte (5) für das fotografische Material (10) und eine Aufzeichnungsträgerfolie (15) mit Zeichen (16) und farbigen Bereichen aufweist, dass das Material der Aufzeichnungsträgerfolie (15) so gewählt ist, dass seine farbigen Bereiche vom Licht der Lichtquelle (3) wenigstens teilweise durchdrungen werden, und dass zur Belichtung ein von Hand über die Auflageplatte (5) bewegliches Blitzgerät (20) vorgesehen ist, dessen Lichtöffnung (22) etwa der Grösse eines Zeichens (16) entspricht und dessen Lichtquelle (25) kurzwelliges Licht abgibt.

2. Vorrichtung nach Anspruch 1, dadurch gekennzeichnet, dass das Blitzgerät (20) zur Dosierung der abgegebenen Lichtmenge ausgebildet ist.

3. Vorrichtung nach Anspruch 1 oder 2, dadurch gekennzeichnet, dass das Blitzgerät (20) mit einer transparenten, ebenen Andruckplatte (23) vor seiner Lichtöffnung versehen ist.

4. Vorrichtung nach Anspruch 3, dadurch gekennzeichnet, dass die Andruckplatte (23) aus Glas besteht.

5. Vorrichtung nach einem der Ansprüche 1–4, dadurch gekennzeichnet, dass die Lichtöffnung (22) des Blitzgeräts (20) durch eine Blende auf die Grösse des jeweils herzustellenden Zeichens (16) verkleinerbar ist.

6. Vorrichtung nach Anspruch 3, 4 oder 5, dadurch gekennzeichnet, dass im Bereich der Lichtöffnung (22) das Blitzgerät (20) eine ebene Seite (21) mit in der gleichen Flächenebene liegenden Andruckplatte (23) aufweist.

7. Vorrichtung nach einem der Ansprüche 3–6, dadurch gekennzeichnet, dass die Andruckplatte (23) aussen mit einer oder mit zwei Aussenwänden des Blitzgeräts (20) bündig abschliesst.

8. Vorrichtung nach einem der Ansprüche 1–7, dadurch gekennzeichnet, dass die Auflageplatte (5) gelb getönt ist.

9. Vorrichtung nach einem der Ansprüche 1–8, dadurch gekennzeichnet, dass die Oberfläche der Auflageplatte (5) zur diffusen Abgabe des Lichts aufgerauht ist.

10. Vorrichtung nach einem der Ansprüche 1–9, dadurch gekennzeichnet, dass die Aufzeichnungsträgerfolie (15) in ihren farbigen Bereichen als Diazofilm hergestellt ist.

11. Vorrichtung nach einem der Ansprüche 1–10, dadurch gekennzeichnet, dass die farbigen Bereiche der Aufzeichnungsträgerfolie (15) orange bis sepiafarben sind, während die von Zeichen (16) eingenommenen Bereiche nicht farbig klar sind.

12. Vorrichtung nach einem der Ansprüche 1–11, dadurch gekennzeichnet, dass eine Deckfolie (12) zum Schutz des mit Entwicklerlösung getränkten fotografischen Materials (10) vorgesehen ist.

13. Vorrichtung nach Anspruch 12, dadurch gekennzeichnet, dass die Deckfolie (12) ein blau gedrucktes Millimeter-Liniennetz (13) aufweist.

14. Verfahren zur fotografischen Herstellung von Schriftzeichen usw. unter Verwendung von mit Entwicklerlösung getränktem fotografischem Material sowie der Vorrichtung nach einem der Ansprüche 1–13, gekennzeichnet durch folgende Massnahmen:

a) zum Schutz gegen Verdunstung der Entwicklerlösung bedeckt eine Deckfolie (12) das fotografische Material (10);

b) die Aufzeichnungsträgerfolie (15) wird auf die Deckfolie (12) mit einem ausgewählten Zeichen (16) an gewünschter Stelle des fotografischen Materials (10) aufgelegt bzw. zurechtgerückt;

c) der Bereich des ausgewählten Zeichens (16) wird mit kurzwelligem Blitzlicht bestrahlt;

d) die Schritte b) und c) werden gegebenenfalls wiederholt.

15. Verfahren nach Anspruch 14, dadurch gekennzeichnet, dass die erzeugten Schriftzeichen fixiert werden.

## Revendications

1. Dispositif pour la fabrication de caractères ou signes semblables, en particulier des prises de vue de titres, sur des matières photographiques (10) imbibées d'une solution de révélateur, qui permet un traitement à la lumière naturelle atténuée, caractérisé en ce qu'il est prévu pour l'observation une boîte à lumière (1) qui comporte une source lumineuse (3) émettant une lumière non actinique, une plaque d'appui (5) plane pour la matière photographique (10) et une feuille support d'enregistrement (15) avec des signes (16) et des zones colorées, en ce que le matériau de la feuille d'enregistrement (15) est choisi tel que ses zones colorées sont traversées au moins en partie par la lumière de la source lumineuse (3) et en ce qu'il est prévu pour l'exposition à la lumière un appareil à flash (20) pouvant être déplacé à la main au dessus de la plaque d'appui (20) dont l'ouverture de lumière (22) correspond sensiblement à la grandeur d'un signe (16) et dont la source lumineuse (25) émet une lumière à faible longueur d'onde.

2. Dispositif selon la revendication 1, caractérisé en ce que l'appareil à flash (20) est doté de moyens de dosage de la quantité de lumière émise.

3. Dispositif selon la revendication 1 ou 2, caractérisé en ce que l'appareil à flash (20) est muni devant son ouverture de lumière d'une plaque de serrage (23) plane transparente.

4. Dispositif selon la revendication 3, caractérisé en ce que la plaque de serrage (23) est en verre.

5. Dispositif selon une quelconque des revendications 1 à 4, caractérisé en ce que l'ouverture de lumière (22) de l'appareil à flash (20) peut être diminuée au moyen d'un diaphragme en fonction de la grandeur du signe (16) à fabriquer.

6. Dispositif selon la revendication 3, 4 ou 5, caractérisé en ce que, dans la zone de l'ouverture de lumière (22), l'appareil à flash (20) comporte un côté plan (21) avec une plaque de serrage (23) se trouvant dans le même plan.

7. Dispositif selon une quelconque des revendications 3 à 6, caractérisé en ce que la plaque de serrage (23) est contigue à l'extérieur à une ou deux parois extérieures de l'appareil à flash (20).

8. Dispositif selon une quelconque des revendications 1 à 7, caractérisé en ce que la plaque d'appui (5) est de couleur jaune.

9. Dispositif selon une quelconque des revendications 1 à 8, caractérisé en ce que la surface de la plaque d'appui (5) est rendue rugueuse afin de diffuser la lumière émise.

10. Dispositif selon une quelconque des revendications 1 à 9, caractérisé en ce que la feuille support d'enregistrement (15) se présente sous la forme d'une film diazo dans ses parties colorées.

11. Dispositif selon une quelconque des revendications 1 à 10, caractérisé en ce que les parties colorées de la feuille support d'enregistrement (15) sont de couleur orange ou sépia tandis que les parties occupées par les signes (16) sont claires et incolores.

12. Dispositif selon une quelconque des revendications 1 à 11, caractérisé en ce qu'il est prévu une feuille de couverture (12) pour protéger la matière photographique (10) imbibée de solution de révélateur.

13. Dispositif selon la revendication 12, caractérisé en ce que la feuille de couverture (12) possède un quadrillage millimétrique (13) imprimé de couleur bleue.

14. Procédé pour la fabrication photographique de caractères ou signes analogues en utilisant une matière photographique imbibée d'une solution de révélateur ainsi que le dispositif selon une quelconque des revendications 1 à 13, caractérisé par les mesures suivantes:

a) pour assurer la portection contre l'évaporation de la solution de révélateur, une feuille de couverture (12) recouvre la matière photographique (10);

b) la feuille support d'enregistrement (15) est placée par un signe (16) choisi ou positionnée par déplacement à l'emplacement souhaité de la matière photographique (10).

c) la zone du signe (16) choisi est exposée à la lumière par un éclair flash à courte longueur d'onde;

d) les phases opératoires b) et c) sont éventuellement répétées.

15. Procédé selon la revendication 14, caractérisé en ce que les caractères obtenus sont traités par fixage.

## Claims

1. Device for photographically producing characters, expecially for caption, on photographic material (10) which is wetted with developing liquid and allows processing under subdued daylight, characterized in that, for observing purposes, a light box (1) is provided comprising a light source (3) for non-actinic light and a flat support plate (5) for the photographic material (10) and a record carrier (5, 15) having characters (16) and coloured regions, that the material of the record carrier film (15) is selected so as its coloured regions are transparent for the light of the light source (3) at least partially, and that a flash device (20) is provided for positioning above the support plate (5) for exposing, the aperture (22) of the flash device corresponding approximately to the size of a character (16) and the light source (25) thereof emitting short wave light.

2. Device according to claim 1, characterized in that the flash device (20) is designed for dosing the light quantity emitted.

3. Device according to claim 1 or 2, characterized in that the flash device (20) is provided with a transparent flat pressure plate (23) arranged before its aperture.

4. A device according to claim 3, characterized in that the pressure plate (23) consists of glass.

5. A device according to one of the claims 1 through 4, characterized in that the aperture (22) of the flash device (20) has a diaphragm which can be narrowed to the size of the character (16) to be just produced.

6. A device according to claim 3, 4 or 5, characterized in that, in the region of the aperture (22), the flash device (20) has a flat face (21) comprising the pressure plate (23) which is arranged in the same plane.

7. A device according to one of the claims 3 through 6, characterized in that the pressure plate (23) adjoins two outside edges of the flash device (20).

8. A device according to one of the claims 1 through 7, characterized in that the support plate (5) is tinted yellow.

9. A device according to one of the claims 1 through 8, characterized in that the surface of the support plate (5) is roughened to deliver diffused light.

10. A device according to one of the claims 1 through 9, characterized in that the record carrier film (15), in its coloured regions, is made up by diazo film.

11. A device according to one of the claims 1 through 10, characterized in that the coloured region of the record carrier film (15) are orange to sepia coloured, whereas the regions of the characters (16) are non-coloured clear.

12. A device according to one of the claims 1 through 11, characterized in that a cover film (12) is provided for protecting the photographic material (10) being wetted with developer liquid.

13. A device according to claim 12, characterized in that the cover film (12) has a blue printed millimeter grit (13).

14. A method for photographically producing characters using photographic material being wetted with developer liquid and the device according to one of the claims 1 through 13, characterized by the following features:

a) a cover film (12) covers the photographic material (10) to protect same against evaporation of the developer liquid;

b) the record carrier film (15) is positioned on the cover film (12) so as to juxtapose a selected character (16) to a desired region of the photographic material (10);

c) the region of the selected character (16) is irradiated by short wave flash light;

d) the steps b and c are eventually repeated.

15. A device according to claim 14, characterized in that the characters produced are fixed.

_Fig. 2_

_Fig. 1_

0 048 297